Europäisches Patentamt

European Patent Office

Office européen des brevets

(11) Publication number: **0 316 009 A2**

(12) **EUROPEAN PATENT APPLICATION**

(21) Application number: 88118838.7

(51) Int. Cl.⁴: **H01L 39/12**

(22) Date of filing: 11.11.88

(30) Priority: **11.11.87 JP 283339/87**
**05.10.88 JP 249872/88**

(43) Date of publication of application:
**17.05.89 Bulletin 89/20**

(84) Designated Contracting States:
**DE FR GB**

(71) Applicant: **HITACHI, LTD.**
**6, Kanda Surugadai 4-chome Chiyoda-ku**
**Tokyo(JP)**

(72) Inventor: **Kozono, Yuzo**
**3234-2, Mayumicho**
**Hitachiota-shi(JP)**
Inventor: **Ohno, Toshiyuki**
**19-3-202, Ishinazakacho-1-chome**
**Hitachi-shi(JP)**
Inventor: **Kasai, Masahiro**
**Yuhoryo 20-3, Ayukawacho-6-chome**
**Hitachi-shi(JP)**
Inventor: **Hanazono, Masanobu**
**935-4, Motoyoshidacho**
**Mito-shi(JP)**
Inventor: **Sugita, Yutaka**
**12-1, Nakaarai-5-chome**
**Tokorozawa-shi(JP)**

(74) Representative: **Patentanwälte Beetz sen. -**
**Beetz jun. Timpe - Siegfried -**
**Schmitt-Fumian- Mayr**
**Steinsdorfstrasse 10**
**D-8000 München 22(DE)**

(54) **Oxide superconductor.**

(57) The present invention provides an oxygen-deficient perovskite type oxide superconductor having a superconducting critical temperature of 90 K or higher and represented by the formula of A-B-C-D, for example, $A_1B_2C_3D_{7-\delta}$, wherein A is at least one of yttrium and rare earth metals of Atomic Numbers 57 to 71, except for Atomic Number 61, B is at least one of alkaline earth metals selected from barium, calcium and strontium, C is copper and D is oxygen, the oxide superconductor containing at least one of elements of Atomic Numbers 81 to 83 substituted for part of A.

FIG. 1

## OXIDE SUPERCONDUCTOR

BACKGROUND OF THE INVENTION

Field of the Invention

The present invention relates to an oxygen-deficient perovskite type oxide superconductor, more particularly to the improvement of the oxide superconductor comprising at least one of yttrium and rare earth metals, at least one of alkaline earth metals, and copper and oxygen. In other words, the present invention relates to the improvement of the oxide superconductor represented by $A_1 B_2 C_3 D_{7-\delta}$, wherein A is at least one of yttrium and rare earth metals, B at least one of alkaline earth metals, C copper and D oxygen.

Related Art

The oxygen-deficient perovskite type oxide sperconductors are known to have a superconducting critical temperature Tc in oders of 90 K. Furthermore, some superconductors comprised mainly of yttrium, barium, copper and oxygen and modified by partial substitution for each component are known. For example, Physical Review Letters, Vol. 58, No. 24, 1987, pp. 2579-2581, discusses that a superconductor comprising yttrium, barium, copper, oxygen and fluorine may have a Tc of 100 K or higher. Physical Review B, Vol. 36, No. 4, 1987, pp. 2308-2310, refers to a superconductor of yttrium- barium-copper oxide wherein aluminum is partially substituted for the yttrium, represented by $(Y_{1-x}Al_x)$ $Ba_2 Cu_3 O_y$. Japanese Journal of Applied Physics, Vol. 26, No. 8, August 1987, pp. L1356-L1358, shows a superconductor having the formula of $(Y_{1-x}Sc_x)$ $(Ba_{1-x}Sr_x)$ $Cu_3 O_y$. Journal of the American Chemical Society, 1987, 109, pp. 2848-2849, discloses a superconductor having a formula of $RBa_2 Cu_3 O_y$ wherein R is Y, Nd, Sm, Eu, Gd, Dy, Ho, Yb, Lu or Sc. In Abstracts No. 3 of the lecture in the Submeeting of the Japanese Physical Society, Autumn 1987, A. Yamasaki et al teach use of Bi and discuss the superconductivity of a Bi-Sr-Cu-O system. Furthermore, in Japanese Journal of Applied Physics, Vol. 26, No. 12, December, 1987, pp. L2080-L2081, J. Akimitsu et al discuss the superconductivity in the Bi-Sr-Cu-O system.

Particularly, Physical Review Letters, Vol. 58, No. 24, pp. 2579-2581 above reports that a superconductor having a critical temperature Tc of 155 K was obtained by substituting fluorine for part of oxygen.

On the other hand, it is known that the superconducting property of an yttrium-barium-copper-oxygen system superconductor is greatly changeable depending upon a degree of oxygen deficiency. Thus, the degree of oxygen deficiency is in general controlled by heat treating the superconductors.

However, in the prior art it is also known to be very difficult to control a degree of oxygen deficiency, degree of fluorine deficiency and proportion of oxygen atoms and fluorine atoms. In the case that an amount of fluorine is substituted for part of oxygen, the superconducting property varies depending upon the controlled degrees of oxygen deficiency and fluorine deficiency, the proportions of oxygen atoms and fluorine atoms and the positions of the substituted atoms.

The superconducting property gets unstable when fluorine atoms are substituted for oxygen atoms at the positions of the oxygen atoms, because the property relies principally on the electronic or magnetic properties of the binary structure of Cu-O atoms. Thus, the property changes with time.

In order to increase the critical temperature Tc without any such change with time, the electronic or magnetic properties of the Cu-O structure is necessary to be changed by partially substituting for Y or Ba at its position another element.

SUMMARY OF THE INVENTION

The object of the present invention is to provide an oxygen-deficient type perovskite oxide superconductor having an A-B-C-D structure wherein A is at least one of yttrium and rare earth metals, B at least one of alkaline earth metals, C copper and D oxygen, and having a critical temperature of higher than that of $YBa_2 Cu_3 O_{7-\delta}$, i.e., having a critical temperature of about 100 or higher, given by substituting for part of A at least one of the elements of Atomic Numbers 81 to 83.

## BRIEF DESCRIPTION OF THE DRAWINGS

Fig. 1 is a graph showing a relationship between the superconducting critical temperature of a Y-Ba-Cu-O system oxide superconductor and the amount of Bi or Tl substituted for part of Y.

Fig. 2 is a graph showing a relationship between the temperature and resistivity of a Y-Ba-Cu-O system oxide superconductor in which Bi is substituted for part of Y.

## DETAILED DESCRIPTION OF PREFERRED EMBODIMENTS

In accordance with the present invention, there is provided an oxygen-deficient type oxide superconductor having an A-B-C-D structure wherein A is at least one of yttrium and rare earth metals, B at least one of alkaline earth metals, C copper and D oxygen, in which at least one of elements of Atomic Numbers 81 to 83 are substituted for part of A.

As the alkaline earth metals may be used any of barium, strontium, calcium and magnesium.

The Atomic Numbers 81 to 83 are thallium (Tl), lead (Pb) and bismuth (Bi), respectively.

As the rare earth metals may be used at least one of lanthanum (La), cerium (Ce), praseodymium (Pr), neodymium (Nd), samarium (Sm), europium (Eu), gadolinium (Gd), terbium (Tb), dysprosium (Dy), holmium (Ho), erbium (Er), thulium (Tm), ytterbium (Yb) and lutetium (Lu).

When the elements to be substituted for part of A are referred to as E, i.e., the superconductor is represented by $A_{1-x}E_xBCD$, the substituted amount x of E is desirably 0.05 to 0.95 for thallium, 0.05 to 0.5 for lead and 0.05 to 0.6 for bismuth.

Preferred combinations of components of the oxide superconductor according to the present invention are Y-Tl-Ba-Ca-Cu-O, Y-Bi-Ba-Cu-O, Y-Bi-Sr-Ca-Cu-O and Y-Tl-Ba-Cu-O.

When Tl is substituted for part of A, the oxide superconductor having a superconducting critical temperature Tc of 110 K or higher may be obtained.

When Bi is substituted for part of A, the oxide superconductor having a superconducting critical temperature Tc of 90 K or higher may be obtained.

When Pb is substituted for part of A, the oxide superconductor having a superconducting critical temperature Tc of 100 K or higher may be obtained.

The present invention particularly provides an oxygen-deficient type oxide superconductor having a formula of $A_1B_2C_3D_{7-\delta}$ wherein A is at least one of yttrium and rare earth metals, B at least one of alkaline earth metals, C copper and D oxygen, featured by substituting at least one of elements of Atomic Numbers 81 to 83 for part of A.

The amount of $\delta$ in the superconductor oxide $A_1B_2C_3D_{7-\delta}$ represents a degree of oxygen deficiency ($0 \leq \delta \leq 1$). When $\delta$ is in the range of less than 0.3, the sperconductor oxide is in an orthorhombic form and, when $\delta$ is more than 0.3, it is in a tetragonal form.

From many experiments regarding quantization of magnetic flux or alternating-current Josephson effect, it has been confirmed until now that with oxide superconductors having a superconducting critical temperature of 90 K or higher, a carrier for superconductive current has an electric charge of 2e. Thus, it is known that the carrier is a pair of electric charge 2e (Cooper pair), but it has not yet been clarified which of lattice vibration (phonon), fluctuation of electric charge (exciton and etc.) or magnetic fluctuation has an effect on superconductivity.

However, from various experiments on oxide superconductors of 90 K or higher, it is considered that the pair of electrons is made due to the strong direct correlation of the electrons with each other (magnetic fluctuation). The strong direct correlation of electrons with each other is considered to mean that the pair of superconducting electrons is made due to the mutual action of spins possessed by the electrons. In other words, interaction between the electrons of each copper atom in the Cu-O-Cu bond (interaction between the spins of the electrons) is significant to the mechanism of giving the superconducting properties. This interaction is intensified by substituting Bi, Tl and/or Pb for part of A of the A-B-C-D superconductor, to achieve a higher critical temperature Tc.

In accordance with the present invention, it has been found that a superconducting critical temperature Tc of 100 K or higher is achieved by substituting Bi, Tl or Pb for part of A of the A-B-C-D superconductor having a critical temperature in the orders of 90 K. This is contributed to by a long mean free path of Bi, Tl and Pb which strengthens the mutual action of electrons in Cu-O-Cu bonds.

According to the present invention, there are given such advantages that the superconducting critical temperature Tc of an oxide superconductor represented by A-B-C-D werein A is at least one of yttrium and rare earth metals, B at least one of alkaline earth metals, C copper and D oxygen, can be raised up to 100 K or higher by substituting Bi, Tl or Pb for part of A, further Tc is not changed with time, and the stable superconductivity can be obtained at a temperature exceeding that of liquid nitrogen.

Furthermore, since the superconducting critical temperature of the oxide superconductor according to the present invention is much higher than the cooling medium temperature (77 K for liquid nitrogen), this oxide superconductor can be used as, for example, various electronics devices or apparatuses for energy with a broader operation margin. Therefore, the scope of applications of the oxide superconductors can be broadened.

The present invention will be further illustrated below with reference to some examples.

EXAMPLE 1

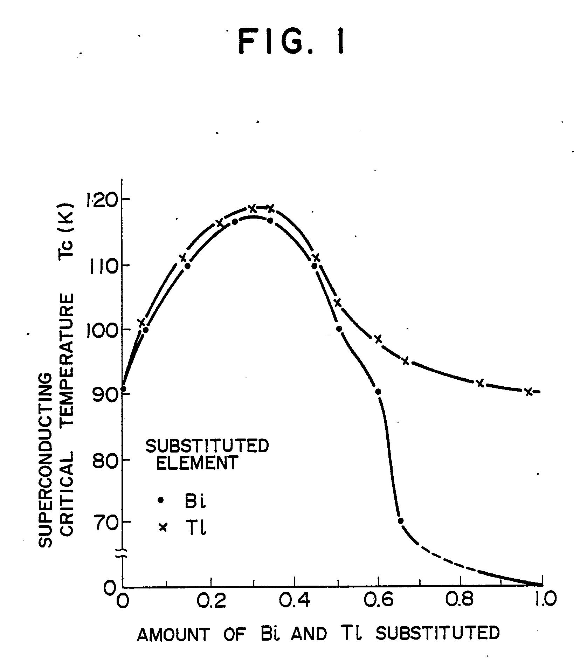

Fig. 1 is a graph showing a relationship between the amount (x) of Bi substituted for part of Y in a Y-Ba-Cu-O oxide superconductor and the superconducting critical temperature Tc of the oxide superconductor.

This oxide superconductor was made by a sputtering method. A spputering target used was comprised of a $BaCuO_2$ target of 100 mm in diameter and 5 mm thick having Y and Cu chips of 5 mm x 5 mm x 1 mm thick placed thereon. Sputtering was carried out so that the composition of a film made was in a Y:Ba:Cu ratio of 1:2:3. Then, a Bi chip or Tl chip was substituted for part of the Y chip, so that the amount (x) of Bi or Tl in the resultant film was in the range of 0 to 1. Sputtering conditions are shown in Table 1.

## Table 1

| Reached degree of vacuum | $< 5 \times 10^{-6}$ Torr |
|---|---|
| Ar gas pressure | $1 - 2 \times 10^{-2}$ Torr |
| Power of high frequency | 200 - 250 W |
| Substrate | Single crystal of MgO (100) <br> Single crystal of $SrTiO_3$ (100) |
| Temperature of substrate | 200 - 300°C |

A thin film of about 1 μm thick was prepared under the sputtering conditions as shown in Table 1. After the sputtering, the thin film was subjected to heat treatment in an oxygen atmosphere at 900 to 1000°C for 2 hours. The heat treatment was carried out at a cooling rate of 1°C/min.

As shown in Fig. 1, Tc is 100 K or higher when an amount x of Bi substituted is in the range of $0.05 \leq x \leq 0.5$. When an amount x of Bi substituted is higher than 0.6, Tc is 90 or higher. Furthermore, Tc is 110 K or higher at an amount of Tl substituted in the range of $0.15 \leq x \leq 0.5$, and Tc is 90 K or higher at an amount of Tl in the range of $0.05 \leq x \leq 0.95$.

The value of Tc was measured herein by a usual four-probe method.

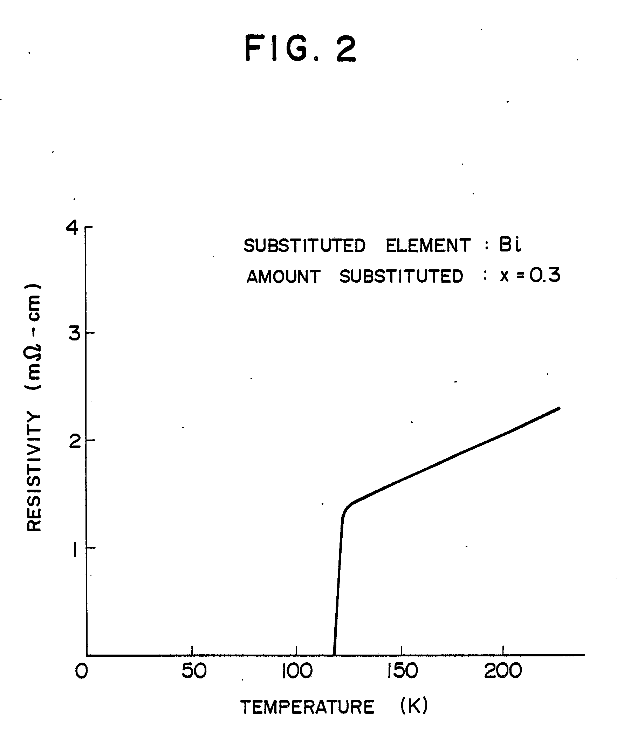

Fig. 2 is a temperature-resistivity graph shown at the Bi amount x of 0.3. The X-ray diffraction pattern revealed that the thin film was in an orthorhombic form at the Bi amount x of 0.3, and it had diffraction peaks which appear to indicate crystals in a form other than the orthorhombic form at the Bi amount x of greater than 0.6. In the latter case, such crystals had a Tc of 90 K or lower. When the Bi amount x substituted was 1, i.e., Y was entirely replaced with Bi, no superconductivity was observed.

Thus, it was found that the oxide superconductors of $(Y_{1-x}Bi_x)_1 Ba_2 Cu_3 O_{7-\delta}$ or $(Y_{1-x}Tl_x)_1 Ba_2 Cu_3 O_{7-\delta}$ had a high critical temperature at the Bi amount x substituted of 0.05 to 0.6, and at the Tl amount x substituted 0.05 to 0.95. Furthermore, the obtained thin film having a $Tc \geq 100$ K had no change observed in its properties even when it was left to stand for a long period of time.

EXAMPLE 2

This example concerns an oxide superconductor of a Y-Bi-Sr-Ca-Cu-O system.

As starting materials were used $Y_2O_3$, $Bi(NO_3)$, $SrCO_3$ $CaCO_3$ and $CuO$. These materials were mixed so that the obtained compositions were $Y_1Bi_1Sr_1Ca_1Cu_2O_z$(*) $(A_2B_2C_2D_z)$ and $Y_0 \cdot 1Bi_0 \cdot gSr_1Ca_1Cu_2O_z$ - $(A_1B_2C_2D_z)$ (**) , respectively. Both were fired at a temperature of 870° C.

The superconducting critical temperature Tc of $Y_1Bi_1Sr_1Ca_1Cu_2O_z$ was 120 K and that of $Y_0 \cdot 1Bi_0 \cdot gSr_1Ca_1Cu_2O_z$ was 110 K.

EXAMPLE 3

This example concerns the oxides of Y-Tl-Ba-Cu-O and Y-Tl-Ba-Ca-Cu-O systems.

As starting materials were used $Y_2O_3$, $Tl_2O_3$, $BaCO_3$, $CaCO_3$ and $CuO$. These materials were mixed so that the desired compositions were obtained, and fired.

Table 2 shows that the compositions of the obtained oxide superconductors, firing temperatures and superconducting critical temperatures Tc. Furthermore, Table 2 shows an oxide of a Y-Ba-Cu-O system.

(*) z denotes the amount of oxygen and varies depending upon proportions of a, b and c and various conditions for preparing the oxide.

(**) d is oxygen which is present in an amount (z) not determinable according to the state of the art and which fact is known to the art

Table 2

| No. | Compositional Ratios | Firing Temp. |
| | Y / Tl /Ba /Ca /Cu | (°C) |
|---|---|---|
| 1 | 1 / 0 / 2 / 0 / 3 | 950 |
| 2 | 0.5 / 0.5 / 2 / 0 / 3 | 840 |
| 3 | 0.5 / 0.5 / 1 / 1 / 3 | 840 |
| 4 | 0.2 / 0.8 / 1 / 1 / 2 | 850 |

Table 2 (Cont'd)

| Critical Temp. $T_c$(°K) | Notes |
|---|---|
| 97 | Comparative Ex. |
| 105 | This invention |
| 120 | " |
| 128 | " |

The superconducting critical temperature could be raised by substituting Tl for part of Y.

EXAMPLE 4

This example concerns the oxide superconductor of a Y-Pb-Sr-Ca-Cu-O system.

As the starting materials were used $Y_2O_3$, $Pb(NO_3)$, $SrCO_3$, $CaCO_3$ and CuO. These materials were mixed so that the composition of $Y_0 \cdot 5Pb_0 \cdot 5Sr_1 Ca_1 Cu_3 O_{7.\delta}$ was obtained, and fired at 870° C.

The superconducting critical temperature $T_c$ was 120 K.

Claims

1. An oxygen-deficient perovskite type oxide superconductor represented by the formula of A-B-C-D, wherein A is at least one of yttrium and rare earth metals of Atomic Numbers 57 to 71, except for Atomic Number 61, B is at least one of alkaline earth metals, C is copper and D is oxygen, said oxide superconductor containing at least one of elements of Atomic Numbers 81 to 83 substituted for part of A.

2. The oxide superconductor according to Claim 1, wherein A denotes $Y_{1-x}Tl_x$ wherein an amount x of Tl substituted is equal to or greater than 0.05 but equal to or smaller than 0.95.

3. The oxide superconductor according to Claim 2, wherein said oxide has a superconducting critical temperature of 110 K or higher.

4. The oxide superconductor according to Claim 1, wherein A denotes $Y_{1-x}Bi_x$ wherein an amount x of Bi substituted is equal to or greater than 0.05 but equal to or smaller than 0.6.

5. The oxide superconductor according to Claim 4, wherein said oxide has a superconducting critical temperature of 90 K or higher.

6. The oxide superconductor according to Claim 1, wherein A denotes $Y_{1-x}Pb_x$ wherein an amount x of Pb substituted is equal to or greater than 0.05 but equal to or smaller than 0.5.

7. The oxide superconductor according to Claim 6, wherein said oxide has a superconducting critical temperature of 100 K or higher.

8. The oxide superconductor according to Claim 1, wherein said alkaline earth metal is at least one selected from barium, calcium, strontium and magnesium.

9. The oxide superconductor according to Claim 1, wherin said oxide is of a Y-Tl-Ba-Ca-Cu-O, Y-Bi-Ba-Cu-O, Y-Bi-Sr-Ca-Cu-O, or Y-Tl-Ba-Cu-O system.

10. An oxyten-deficient perovskite type oxide superconductor represented by one of the formulae of $A_1B_2C_3D_{7-\delta}$, $A_2B_2C_2D_z$ and $A_1B_2C_2D_z$, wherein A is at least one of yttrium and rare earth metals of Atomic Numbers 57 to 71, except for Atomic Number 61, B is at least one of alkaline earth metals, C is copper and D is oxygen, said oxide superconductor containing at least one of elements of Atomic Numbers 81 to 83 substituted for part of A.

11. The oxide superconductor according to Claim 10, wherein A denotes $Y_{1-x}Tl_x$ wherein an amount x of Tl substituted is equal to or greater than 0.05 but equal to or smaller than 0.95.

12. The oxide superconductor according to Claim 11, wherein said oxide has a superconducting critical temperature of 110 K or higher.

13. The oxide superconductor according to Claim 10, wherein A denotes $Y_{1-x}Bi_x$ wherein an amount x of Bi substituted is equal to or greater than 0.05 but equal to or smaller than 0.6.

14. The oxide superconductor according to Claim 13, wherein said oxide has a superconducting critical temperature of 90 K or higher.

15. The oxide superconductor according to Claim 10, wherein A denotes $Y_{1-x}Pb_x$ wherein an amount x of Pb substituted is equal to or greater than 0.05 but equal to or smaller than 0.5.

16. The oxide superconductor according to Claim 15, wherein said oxide has a superconducting critical temperature of 100 K or higher.

17. The oxide superconductor according to Claim 10, wherein said alkaline earth metal is at least one selected from barium, calcium, strontium and magnesium.

18. The oxide superconductor according to Claim 10, wherein said oxide is of a Y-Tl-Ba-Ca-Cu-O, Y-Bi-Ba-Cu-O, Y-Bi-Sr-Ca-Cu-O, or Y-Tl-Ba-Cu-0 system.

19. The oxide superconductor according to Claim 10, said oxide having a formula of $Y_0 \cdot 2Tl_0 \cdot 8Ba_1 Ca_1 Cu_2 O_z$ and a superconducting critical temperature of 128 K.

20. The oxide superconductor according to Claim 10, said oxide having a formula of $Y_1 Bi_1 Sr_1 Ca_1 Cu_2 O_z$ and a superconducting critical temperature of 120 K.

21. The oxide superconductor according to Claim 10, said oxide having a formula of $Y_0 \cdot 1Bi_0 \cdot 9Sr_1 Ca_1 Cu_2 O_z$ and a superconducting critical temperature of 110 K.

# FIG. 1

# FIG. 2

SUBSTITUTED ELEMENT : Bi
AMOUNT SUBSTITUTED : x = 0.3